## Europäisches Patentamt
## European Patent Office
## Office européen des brevets

(19)

(11) Veröffentlichungsnummer: **0 000 897**
**B1**

(12) **EUROPÄISCHE PATENTSCHRIFT**

(45) Veröffentlichungstag der Patentschrift: **23.12.81**

(21) Anmeldenummer: **78100614.3**

(22) Anmeldetag: **07.08.78**

(51) Int. Cl.³: **H 01 L 21/76,**
**H 01 L 21/263**

(54) Verfahren zum Herstellen von lateral isolierten Siliciumbereichen.

(30) Priorität: **15.08.77 US 824361**

(43) Veröffentlichungstag der Anmeldung:
**07.03.79 Patentblatt 79/5**

(45) Bekanntmachung des Hinweises auf die Patenterteilung:
**23.12.81 Patentblatt 81/51**

(84) Benannte Vertragsstaaten:
**DE FR GB**

(56) Entgegenhaltungen:
**DE - A - 2 617 483**
**FR - A - 2 240 528**
**US - A - 3 796 612**
**US - A - 3 966 577**

**IBM TECHNICAL DISCLOSURE BULLETIN, vol. 18, Juli 1975, Armonk, N.Y. 10504, J. S. LECHATON und D. C. SMITH "Dielectric isolation using a high-resputtering deposition" Seiten 382 und 383**

**SOLIDE STATE TECHNOLOGY, vol. 19, September 1976 Port Washington L.I.N.Y. 11050, A. JACOB "The Versatile Technique of RF Plasma Etchin" Seiten 70—73**

(73) Patentinhaber: **International Business Machines Corporation**
**Armonk, N.Y. 10504 (US)**

(72) Erfinder: **Bondur, James Allan**
**117 Wait Street**
**Walden New York 12586 (US)**
Erfinder: **Pogge, Hans Bernhard**
**R.D. No. 3, La Due Road**
**Hopewell Junction New York 12533 (US)**

(74) Vertreter: **Oechssler, Dietrich, Dr.rer.nat. Dipl.-Chem.**
**Schönaicher Strasse 220**
**D-7030 Böblingen (DE)**

## Verfahren zum Herstellen von lateral isolierten Siliciumbereichen

Die Erfindung betrifft ein Verfahren zum Herstellen von lateral isolierten Bereichen in einem Siliciumkörper, bei dem Nuten an den Stellen, an welchen der Isolationsrahmen entstehen soll, mittels reaktiven Ionenätzens in das Silicium geätzt, anschließend oberflächlich thermisch oxidiert und dann mit dielektrischem Material gefüllt werden, wobei das dielektrische Material mit der notwendigen Dicke ganzflächig auf den Siliciumkörper aufgebracht wird, um die Oberfläche über der Nut zu planarisieren, und schließlich das dielektrische Material außerhalb der Nuten weggeätzt wird.

Bei der Herstellung monolithischer integrierter Schaltungen ist es normalerweise notwendig, verschiedenartige aktive und passive Bauelemente in der integrierten Schaltungsstruktur voneinander zu isolieren. Solche Bauteile sind voneinander mittels des Anlegens einer Sperrvorspannung, mittels P/N-Übergängen und mittels teilweiser oder vollständiger dielektrischer Isolation isoliert. Die dielektrischen Materialien, welche benutzt worden sind, sind Siliciumdioxid, Glas usw. Die bevorzugte Isolation für diese aktiven Bauteile und Schaltkreise ist irgendeine Art der dielektrischen Isolation. Die dielektrische Isolation hat dadurch einen wesentlichen Vorteil gegenüber der Isolation mittels eines P/N-Übergangs, daß sie das Anstoßen von Schaltkreiselementen an die Isolation erlaubt, was eine größere Packungsdichte der aktiven und passiven Bauteile auf dem Chip mit den integrierten Schaltungen ermöglicht.

Zu einer Art dielektrischen Isolation gehört die Bildung von Nuten oder Vertiefungen an den Stellen im Silicium, wo die Isolationsbereiche gebildet werden sollen. Während der Bildung der Nuten ist der Rest der Siliciumoberfläche durch einen Schutzfilm geschützt, welcher von dem Siliciumätzmittel, welches dazu benutzt wird, um die Nuten zu erzeugen, praktisch nicht angegriffen wird. Der übliche Schutzfilm besteht aus einer Doppelschicht aus Siliciumnitrid und Siliciumdioxid. Nach der Bildung der Nuten mittels des üblichen chemischen Ätzens, wird der Siliciumkörper einem wohlbekannten Oxidationsschritt unterworfen, wobei das Silicium im Bereich der Nut oxidiert wird und dabei einerseits die Nut mit Siliciumdioxid gefüllt wird und andererseits die stehengebliebenen Siliciumbereiche noch weiter auseinanderrücken. Eines der Hauptprobleme, welches bei diesem Prozeß auftritt, ist unter dem Namen "Vogelschnabel" (bird's beak) bekannt.

Der "Vogelschnabel" ist ein nicht planares Gebilde aus Siliciumdioxid, am oberen Rand der Nut, und wird verursacht durch die laterale Oxidation des Siliciums unter der Siliciumnitridschicht. Da bei der Oxidation von Silicium das entstandene Siliciumdioxid etwa den doppelten Raum einnimmt, und da das Siliciumnitrid die uneingeschränkte Ausdehnung des entstehenden Oxidmaterials begrenzt, erfolgt ein Nachobenstoßen des Siliciumnitrids am Rand der Nut. Aus diesem Phänomen folgen schließlich mechanische Spannungen in der unmittelbaren Umgebung der Nut außerdem Schwierigkeiten anschließend mittels Diffusion dotierte Gebiete zu erzeugen, welche direkt an den vertikalen Teil des Siliciumdioxids anstoßen. Aufgrund dieser Schwierigkeit, ein direktes Anstoßen zu erreichen, tritt ein wesentlicher von dem Siliciumdioxidbereich erhoffter Vorteil nicht ein. Dieses oben beschriebene Verfahren ist vollständiger und detaillierter in den US—Patenten 3 970 486, 3 534 234 und 3 648 125 und in der deutschen Offenlegungsschrift 22 18 892 beschrieben.

Andere Verfahren zur Herstellung dielektrischer Isolationen sind in dem US—Patent 3 386 865 und in dem Artikel "A Composite Insulator-Junction Isolation" von R. E. Jones u.a., welcher in der Zeitschrift Electrochemical Technology, Bd. 5, Nr. 5—6, Mai-Juni 1967, auf den Seiten 308 bis 310 veröffentlicht ist, beschrieben. Bei diesem Verfahren wird eine Siliciumdioxidschicht oder eine Schicht ähnlichen Typs auf dem Substrat in dem Bereich, wo die dielektrische Isolation erwünscht ist, erzeugt. Dann wird auf dem Substrat überall dort, wo sich kein Siliciumdioxid befindet, eine Epitaxieschicht aufgewände. Die Oberfläche der Epitaxieschicht und die Seitenwände der Fenster in der Epitaxieschicht werden teilweise thermisch oxidiert. Die Fenster werden dann mittels Niederschlagens aus der Dampfphase mit polykristallinem Silicium, Siliciumdioxid oder ähnlichen Materialien gefüllt. Dieses Verfahren hat einige Nachteile. Das selektive Aufwachsen einer Epitaxieschicht, wie es dieses Verfahren erforderlich macht, ist sehr stark abhängig von dem Flächenverhältnis von Silicumdioxid-Bereichen zu Silicium-Bereichen. Beispielsweise würden auf zwei Siliciumbereichen, welche unterschiedlich groß sind, das Halbleitermaterial mit unterschiedlicher Geschwindigkeit aufwachsen, so daß am Ende des Verfahrensschritts die Epitaxieschicht in diesen Bereichen unterschiedlich dick ist. Beim Aufwachsen von Mesastrukturen ist auch die Tendenz zur kristallographischen Facettenbildung vorhanden. Dies hat ein pyramidenartiges Wachstum zur Folge und führt zu einer Verbreiterung der Isolationsbereiche, welche mit lithographischen Mitteln nicht korrigierbar ist. Die abgeböschte Grenzfläche zwischen dem Silicium und dem Siliciumdioxid macht es auch schwierig, ein Anstoßen von diffundierten Bereichen an den Siliciumdioxidbereich zuverlässig zustande zu bringen.

Die Bildung von Nuten und das Füllen solcher Nuten ist noch in anderen Veröffentlichungen, wie z.B. den US—Patenten 3 892 608 und 3 969 168 beschrieben worden. In diesen Patenten wird chemisches Ätzen dazu benutzt, um eine V-förmige Nut, eine Nut mit gerundetem Boden oder einen ausgehöhlten Raum mit rechteckigem Querschnitt zu erzeugen. Die Patente enthalten wenig Einzelheiten darüber, wie die Nut erzeugt wird, aber es ist klar, daß man bei der Ausbildung der Nut durch die Natur des chemischen Ätzschritts beschränkt ist. Der Prozeß erzeugt nicht notwendigerweise eine ebene Oberfläche und nach der Bildung der Nuten ist ein photolithographischer Verfahrensschritt notwendig. In dem US—Patent 3 956 033 ist ein ähnliches chemisches Verfahren zum Ätzen von Nuten beschrieben, an welches sich ein Füllen der Nuten mit polykristallinem Silicium anschließt. Auch hier ist man bei der Ausgestaltung der Nut durch die chemische Ätztechnik eingeschränkt und es ist unklar, wie das übergewachsene Polysilicium entfernt wird. Auch in den US—Patenten 3 725 160 und 3 979 237 ist das Füllen von Nuten beschrieben. In diesen Patenten ist die Wirkung des chemischen Ätzens klarer beschrieben. Es wird dort zur Herstellung von Nuten mit symmetrisch ausgebildeten Seitenwänden und exakten von der Kristallorientierung der Siliciumoberfläche abhängigen Steigungswinkeln das einkristalline Silicium bevorzugt chemisch geätzt. Im US—Patent 3 979 765 ist ein chemisches Ätzverfahren zum Erzeugen von Nuten mit rechteckigem Querschnitt und das Füllen der Nuten mit Isoliermaterial beschrieben. Es ist jedoch schwierig, anhand der Beschreibung zu verstehen, wie einige der hauptsächlichsten Schritte, wie z.B. das Ätzen und das Füllen, wirklich durchgeführt werden.

Aus der Zeitschrift IBM Technical Disclosure Bulletin, Band 18, Juli 1975, Seiten 382 bis 383 ist ein Verfahren zum Herstellen von lateral isolierten Bereichen in einen Siliciumkörper bekannt, bei dem nach der Erzeugung von Nuten, welche sich mit der Tiefe verjüngen und einen flachen Boden aufweisen, in Siliciumkörper, ganzflächig auf den Siliciumkörper dielektrisches Material aufgebracht und außerhalb der Nuten weggeätzt wird, bei dem nach dem Wegätzen des dielektrischen Materials der Siliciumkörper bei einer Temperatur von etwa 1000°C einer oxidierenden Atmosphäre ausgesetzt wird, so daß sich auf der Grenzfläche zwischen dem Siliciumkörper und dem dielektrischen Material eine thermisch aufgewachsene Siliciumdioxidschicht bildet, und bei dem in den Bodenbereichen der Nuten vor dem Auffüllen der Nut mit dem dielektrischen Material und dem thermischen Oxidieren, Verunreinigungen, welche eine P-Leitfähigkeit vermitteln, in einer solchen Menge eingeführt werden, daß lokal ein Bereich vom $P^+$-Typ ensteht.

Die Herstellung von Nuten mit rechteckigem Querschnitt mittels der reaktiven Ionenätztechnik ist in den US-Patenten 3 966 577 und 3 997 378 und in dem Artikel "Recessed Oxide Isolation Process" von S. A. Abbas im IBM Technical Disclosure Bulletin, Band 20, Nr. 1, Juli 1977, Seite 144 beschrieben. Keine dieser Veröffentlichungen beschreibt die Probleme, welche bei der Bildung von Nuten in Silicium mittels reaktiven Ionenätzens auftreten, und Lösungen für diese Probleme. Diese Veröffentlichungen befassen sich auch nicht mit dem Problem, wie die Nuten effektiv gefüllt werden können, um die bestmögliche Isolation der Siliciumbereiche zu erzeugen. Beschreibungen des Ätzverfahrens mit reaktiven Ionen sind in dem Artikel "A Survey of Plasma-etching Processes" von R. L. Bersin, in der Zeitschrift Solid State Technology, 19. Mai 1976, Seiten 31 bis 36 und speziell für Silicium in der DE—AS 26 17 483 beschrieben. Aus der zuletzt genannten Schrift ist es außerdem bekannt, für das reaktive Ionenätzen eine Maske aus Siliciumdioxid und ein reaktives Gas zu verwenden, welches aus einem Halogen der Gruppe Chlor, Brom, Jod bzw. aus einem eines dieser Elemente enthaltenden Materials besteht, sowie in einer Argonatmosphäre zu arbeiten, welcher als reaktives Gas Chlor zugesetzt wird. Jedoch geht aus den genannten Veröffentlichungen nicht hervor, wie das reaktive Ionenätzen bei der Herstellung einer dielektrischen Isolation benutzt werden kann.

Es ist die Aufgabe der Erfindung, ein relativ einfaches Verfahren zum Herstellen von lateral isolierten Bereichen in einem Siliciumkörper anzugeben, mit dem einerseits eine gute Isolierung erreichbar ist und andererseits dem Erfordernis einer sehr hohen Packungsdichte der Halbleiterbauteile genügt wird.

Diese Aufgabe wird mit einem Verfahren gemäß dem Patentanspruch 1 gelöst. Die im ersten Teil des Anspruchs 1 enthaltenen Merkmale des Anmeldungsgegenstandes sind aus der US—A 3 966 577 bekannt.

Mit dem erfindungsgemäßen Verfahren ist es möglich, die Nuten mit einem Isoliermaterial zu füllen, welches eine hohe Dielektrizitätskonstante und eine hohe Dichte hat und keine störenden Einschlüsse aufweist. Dies wird im wesentlichen dadurch erreicht, daß sich die Nuten mit der Tiefe in festgelegter Weise verjüngen, wodurch ein durch die Geometrie praktisch unbehindertes Zuwachsen der Nuten ermöglicht wird. Bei Anwendung des erfindungsgemäßen Verfahrens erhält man eine obere Oberfläche des dielektrischen Materials in den Nuten, welche im wesentlichen koplanar mit der Oberfläche des Siliciumkörpers ist. Die Planarität der erzeugten Struktur erleichtert die Herstellung zuverlässiger, sehr dicht gepackter integrierter Schaltungen. Es sei an dieser Stelle noch angemerkt, daß in der Beschreibung des erfindungsgemäßen Verfahrens die Ausdrücke "Öffnung", "Kanal", "Loch", "Nut" und "Rille" zur Bezeichnung derselben Sache benutzt werden.

Beim reativen Ionenätzen geht man in vorteilhafter Weise so vor, daß ein reaktives Gas verwendet wird, welches aus einem ein Halogen aus der Gruppe Chlor, Brom, Jod bzw. einem eines dieser Elemente enthaltenden Material besteht und der Reaktionsatmosphäre in Mengen im Bereich zwischen etwa 2 und etwa 10% zugesetzt wird, daß bei einem Druck im Bereich zwischen etwa 2,66 und etwa 66 $\mu$bar gearbeitet und die Ätzgeschwindigkeit auf einen Wert im Bereich zwischen etwa 0,03 und 0,08 $\mu$m/Min. eingestellt wird. Um diese Bedingungen einhalten zu können, wird bei einer Leistungsdichte im Bereich zwischen etwa 0,1 und etwa 0,75 W/cm² geätzt.

Das erfindungsgemäße Verfahren ist insbesondere auch dann vorteilhaft, wenn ein Siliciumkörper verwendet wird, welcher mindestens eine hoch dotierte Schicht enthält und die Nuten so tief geätzt werden, daß sie im wesentlichen die hoch dotierte Schicht durchdringen. Beim Vorliegen einer solchen hoch dotierten Schicht ist es auch beim reaktiven Ionenätzen schwierig, eine starke Unterätzung in lateraler Richtung zu vermeiden, was Probleme aufwirft, wenn eine besonders hohe Packungsdichte der Halbleiterbauteile gefordert wird. Eine besonders geringe Unterätzung erhält man, wenn man bei der Durchführung des erfindungsgemäßen Verfahrens als reaktives Gas Chlor nimmt und dieses im Mengen zwischen etwa 2 und etwa 8% der Reaktionsatmosphäre zumischt.

Es ist vorteilhaft, wen zur Erzeugung eines festgelegten Verjüngungswinkels in bekannter Weise auf der auf dem Siliciumkörper aufgebrachten SiO₂-Schicht eine entsprechend dem gewünschten Muster der Nuten ausgebildete Photolackmaske hergestellt wird und wenn dann die SiO₂-Schicht so reaktiv geätzt wird, daß das Ätzgeschwindigkkeitenverhältnis von SiO₂ zu Photolack ungefähr eins ist. Unter dem Verjüngungswinkel wird in diesem Zusammenhang der Winkel verstanden, welchen die Seitenwand einer sich mit der Tiefe verjüngende Nut mit der Vertikalen bilden. Bei den bekannten Herstellungsverfahren für Photolackmasken werden Maskenfenster erhalten, welche sich mit der Tiefe verjüngen. Beim Ätzen des SiO₂ unter den angegebenen Bedingungen erhält man dann Öffnungen, deren Seitenwände einen Verjüngungswinkel im Bereich zwischen etwa 5 und etwa 20° aufweisen. Beim Ätzen des Siliciums Unter Verwendung der SiO₂-Maske ist es dann sichergestellt, daß sich auch die Nut mit der Tiefe verjüngt, wobei der sich ausbildende Verjüngungswinkel zusätzlich vom Si/SiO₂-Ätzgeschwindigkeitenverhältnis abhängt.

Um eine Planarisierung der erzeugten Struktur mit einem möglichst geringen Aufwand zuverlässig zu erzielen, ist es vorteilhaft, wenn das zum Füllen der Nuten verwendete dielektrische Material mittels chemischen Niederschlagens aus der Dampfphase erzeugt wird und in einer Dicke im Bereich zwischen etwa 1 und etwa 5 $\mu$m abgeschieden wird, wobei die für die Planarisierung notwendige Mindestdicke in Abhängigkeit von der Breite der Nut am oberen Rand festgelegt wird und wenn das dielektrische Material außerhalb der Nuten mittels reaktiven Ionenätzens entfernt wird.

Wenn die Nuten bis in einen Bereich vom P-Typ reichen, so ist zur Verhinderung einer Inversion vorteilhaft, in den Bodenbereichen der Nuten vor dem thermischen Oxidieren Verunreinigungen, welche eine P-Leitfähigkeit vermitteln in einer solchen Menge zu implantieren, daß lokal ein Bereich vom P⁺-Typ entsteht.

Weitere besondere Ausführungsarten des erfindungsgemäßen Verfahrens sind aus den Unteransprüchen zu ersehen.

Die Erfindung wird anhand von durch Zeichnungen erläuterten Ausführungswegen beschrieben. Es zeigen:

(Fortsetzung auf der ursprünglichen Seite 8 der Beschreibung)

Fign. 1A bis 1E verschiedene Stadien der Herstellung der dielektrischen Isolationsstruktur gemäß der Erfindung,

Fig. 2 ein Diagramm zur Erläuterung des Überätzproblems bei hochdotierten Siliciumbereichen unter verschiedenen Ätzbedingungen,

Fign. 3 und 4 Schnitte durch zwei Isolationsstrukturen, welche das Problem des Füllens von sich mit der Tiefe verjüngenden Löchern je nach dem Winkel zwischen der Lochwand und der Vertikalen (Verjüngungswinkel) illustrieren sollen,

Fig. 5 einen Schnitt durch eine Isolationsstruktur, welche das Problem des Füllens sich verjüngender Löcher, welche alle denselben Verjüngungswinkel aber unterschiedliche Lochdurchmesser aufweisen, illustrieren soll,

Fig. 6 in einem Diagramm die experimentell festgestellte Abhängigkeit des Lochwandverjüngungswinkels von der Dicke des mittels chemischen Niederschlagens aus der Dampfphase in den Löchern als Füllung abgeschiedenen Siliciumdioxids ($CVD_{SiO_2}$),

Fig. 7 in einem Diagramm die experimentell ermittelte Abhängigkeit der Erstreckung des Füllungsspalts in der dielektrischen Füllung der Nut bis über oder unter die Halbleiteroberfläche $\Delta l$ von dem Lochdurchmesser für verschiedene Verjüngungswinkel und

Fign. 8, 9 und 10 Diagramme, welche Besonderheiten beim Füllen der Löcher mit dielektrischem Material aufzeigen.

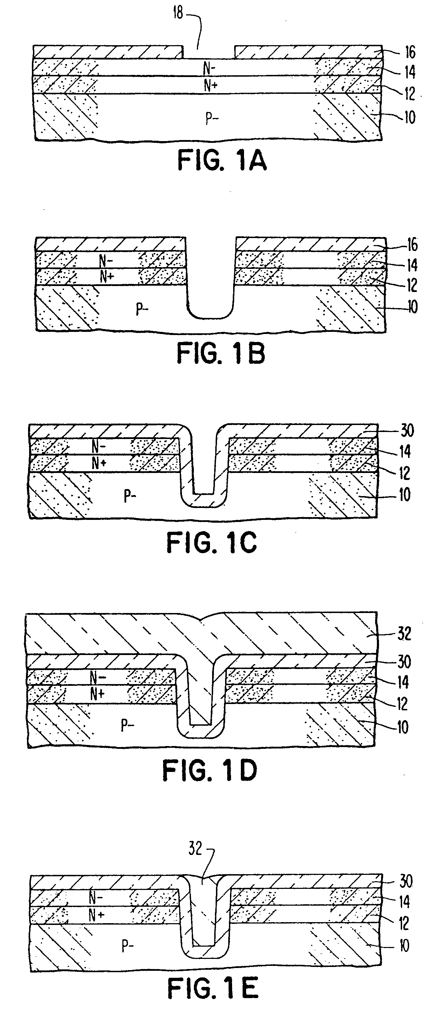

Anhand insbesondere der Fign. 1A bis 1E werden nun die Schritte zur Herstellung der dielektrischen Isolation gemäß eines Ausführungsweges der Erfindung beschrieben. Die in der Fig. 1A gezeigte Struktur schließt ein das einkristalline Siliciumsubstrat 10, welches aus Gründen der Illustration als zum P⁻-Typ zugehörig bezeichnet ist, eine auf dem Substrat 10 aufgebrachte Schicht 12 vom N⁺-Typ und eine auf der Schicht 12 aufgebrachte Schicht 14 mit einer N⁻-Leitfähigkeit. Die Erfindung ist auch anwendbar, wenn alle oder einige der Schichten 10, 12 und 14 von einem Leitfähigkeitstyp wären, welcher dem angegebenen entgegengesetzt ist. Jedoch besteht die Schicht 12 bevorzugt aus einem Bereich mit hoher Leitfähigkeit, damit sie in der endgültigen Struktur die Funktion des Kollektors eines bipolaren Transistors übernehmen kann. Diese Struktur kann mittels verschiedener Herstellungsverfahren erzeugt werden. Die bevorzugte Technik besteht jedoch darin, von einem einkristallinen Siliciumsubstrat vom $P^-$-Typ auszugehen und dann ganzflächig eine Verunreinigung, beispielsweise Arsen, Antimon oder Phosphor, welche eine Leitfähigkeit vom N-Typ erzeugt, mittels Diffusion oder Ionenimplantation ganzflächig in das Siliciumsubstrat hineinzubringen. Auf diese Weise läßt sich eine Schicht vom $N^+$-Typ erzeugen, bei der die Oberflächenkonzentration der Verunreinigung im Bereich zwischen etwa $1 \times 10^{19}$ und $1 \times 10^{21}$ Atomen/cm³ liegt. Die Schicht 14 wird anschließend auf die Schicht 12 mittels Epitaxie aufgewachsen. Dies kann mittels bekannter Verfahren beispielsweise so gemacht werden, daß man Mischungen aus $SiCL_4$ und $H_2$ oder $SiH_4$ und $H_2$ bei Temperaturen im Bereiche zwischen etwa 1000 und etwa 1200°C auf das Substrat einwirken läßt. Die Schicht vom $N^+$-Typ hat eine typische Dicke im Bereich zwischen etwa 1 und 3 $\mu$m, während die Epitaxieschicht eine Dicke im Bereich zwischen etwa 0,5 und 10 $\mu$m hat, wobei die genaue Dicke von den Bauteil, welches hergestellt werden soll, abhängt. Alternativ könnte die Struktur mittels verschiedenartiger Kombinationen von thermischer Diffusion, Ionenimplantation und/oder epitaxialem Aufwachsen hergestellt werden.

Diese Verfahren würden die Bildung eines verschiedenartig ausgebildeten Subkollektorbereichs an den Stellen einschließen, an welchen die Bildung von Bipolarbauteilen erwünscht ist.

Bei bestimmten Bauteilstrukturen sind hochdotierte vergrabene Bereiche oder Schichten nicht notwendig und können deshalb weggelassen werden. Dies trifft beispielsweise für FET-Bauteile zu. Andererseits können eine Vielzahl von vergrabenen hochdotierten Bereichen von unterschiedlichen Dotierungstypen mittels einer Vielzahl von Epitaxie- und Diffusionsverfahrensschritten hergestellt werden. Diese Strukturen könnten sowohl für vergrabene Subkollektoren als auch für vergrabene Leitungen benötigt werden.

Die nächste Gruppe von in den Fign. 1A und 1B gezeigten Verfahrensschritten betreffen das Ätzen von Öffnungen oder Kanälen in die Siliciumstruktur, welche sich mit der Tiefe verjüngen, mittels reaktiver Ionen. Eine Siliciumdioxidschicht 16 wird mittels bekannter Verfahren, d.h. entweder mittels thermischen Aufwachsens bei einer Temperatur von 970°C in einer nassen oder trockenen Sauerstoffatmosphäre oder mittels chemischen Niederschlagens aus der Dampfphase erzeugt. Andere Maskenmaterialien, wie z.B. Siliciumnitrid oder Aluminiumoxid oder Kombinationen dieser Materialien usw., können auch benutzt werden. Die Öffnungen 18 werden in der Oxidschicht in den Bereichen erzeugt, in welchen eine dielektrische Isolation gewünscht wird. Diese Öffnungen werden mittels der üblichen Photolithographie- und Ätztechniken erzeugt. Die in der Fig. 1A gezeigte Struktur ist nun für den Ätzprozeß mittels reaktiver Ionen vorbeiet. Eine genauere Beschreibung dieses Prozesses enthält die oben erwähnte deutsche Offenlegungsschrift 2 617 483. Das mit Hochfrequenz erregte Plasma besteht, wie in der genannten Offenlegungsschrift ausgeführt ist, aus einem reaktives Chlor, Brom oder Jod enthaltenden Material. Die Dicke der Maskierungsschicht 16 liegt im Bereich zwischen etwa 0,2 und 2 $\mu$m, wobei die genaue Dicke von der erforderlichen Tiefe des herzustellenden Loches bzw. der herzustellenden Nut in dem Silicium abhängt. Die genaue Beschreibung der Hochfrequenz-Entladungsvorrichtung wird in de genannten Offenlegungsschrift gegeben. Die Atmosphäre beim reaktiven Ionenätzen bzw. die Plasmaatmosphäre besteht bevorzugt aus einer Kombination eines inerten Gases, wie z.B. Argon mit einem Chlor enthaltendem Material. Eine mittels einer Hochfrequenzspannungsquelle erzeugte Leistungsdichte in der Größenordnung von etwa 0,1 bis 0,75 W/cm² verursacht ein reaktives Ionenätzen des Siliciums, bei dem dieses mit einer Geschwindigkeit im Bereich zwischen etwa 0,02 und etwa 0,08 $\mu$m pro Minute abgetragen wird. Das erwünschte Ätzergebnis ist in der Fig. 1B gezeigt, in der zu sehen ist, daß die Öffnungen oder Kanäle mindestens teilweise den Bereich 10 vom P-Leitfähigkeitstyp durchdringen. Die Kanäle oder Öffnungen gehen in jedem Fall weitgehend durch den Bereich 12 vom $N^+$-Typ hindurch.

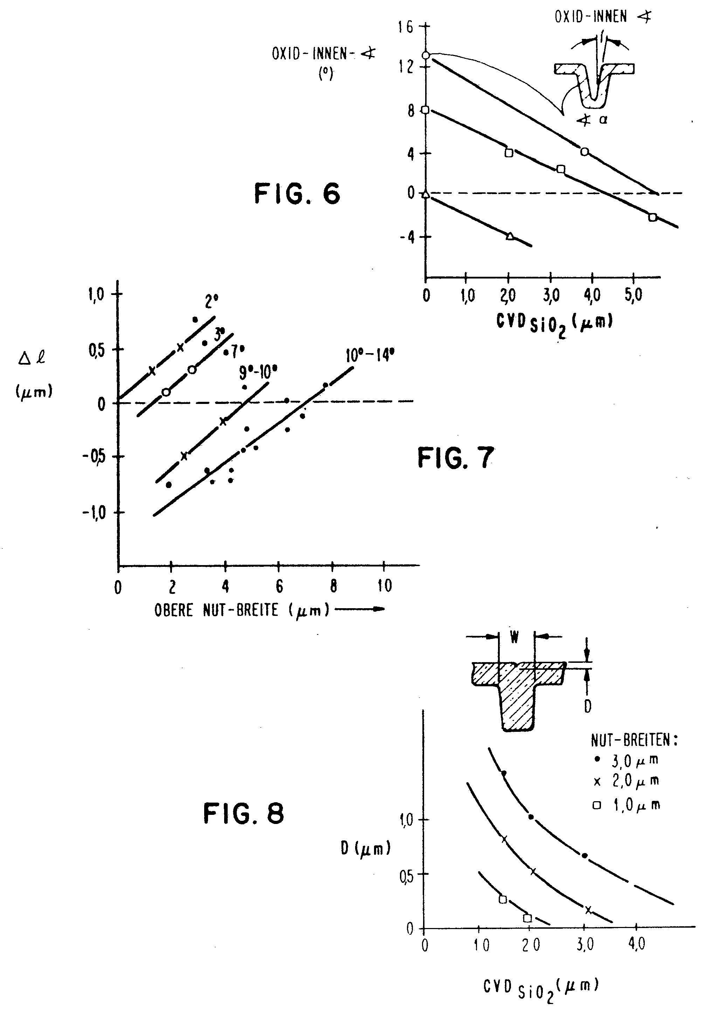

Es ist wichtig, daß die Öffnungen oder Kanäle sich mit der Tiefe mindestens so stark verjüngen, daß der Winkel zwischen der Öffnungswand und der Vertikalen größer als etwa 2° ist. Dies ist deshalb notwendig, weil bei dem nachfolgenden Verfahrensschritt des Füllens mit dielektrischem Material das Abscheiden in der Nähe des oberen Randes der Nut etwas rascher erfolgt als am Boden der Nut. Würde man von Löchern bzw. Nuten mit senkrechten Wänden ausgehen, so würde irgendwann einmal während des Abscheidens ein Zuwachsen des dann noch vorhandenen schmalen Lochs in der Nähe des oberen Lochrandes stattfinden, mit dem Ergebnis, daß das dielektrische Material in dem Bereich unter dem zugewachsenen Bereich eine schlechte Qualität hätte. Im Fall einer sich im ausreichenden Maß mit der Tiefe verjüngenden Nut, wird die Nut von ihrem Boden her gefüllt. Der bevorzugte Verjüngungsgrad, welcher für ein geeignetes Füllen mit dielektrischem Material, wie z.B. Siliciumdioxid, mittels chemischen Niederschlagens aus der Dampfphase geeignet ist, wird teilweise, was bei der Besprechung der Fig. 6 klar werden wird, von der Nutbreite abhängen. Ein Verjüngungswinkel, welcher größer als 20° ist, nimmt eine unnötig große Fläche auf der Oberfläche des Halbleiterbauteils in Anspruch. Diese Bildung der Struktur mit den sich verjüngenden Nuten oder Löchern, hängt hauptsächlich von zwei Faktoren ab. Der erste Faktor ist der Winkel der Seitenwand der Öffnung 18 in der Maskierungsschicht 16. Der zweite Faktor ist der Unterschied in den Geschwindigkeiten, mit denen das Maskenmaterial und das Substratmaterial geätzt werden. Je höher das Verhältnis der Geschwindigkeiten ist, mit denen das Substratmaterial und das Maskenmaterial geätzt werden, um so vertikaler werden die Lochwände im Siliciumsubstrat.

Bei der Anwendung überlicher lithographischer Techniken, werden im allgemeinen Öffnungen im Photolack erhalten, welche sich mit der Tiefe etwas verjüngen. Wird dann das reaktive Ionenätzen dazu benutzt, um in dem darunterliegenden Siliciumdioxidfilm durch die sich verjüngenden Fenster im Photolack Öffnungen zu erzeugen, und wenn das Verhältnis der Geschwindigkeit des Lackätzens zu der des Siliciumdioxidätzens ungefähr eins ist, wird die im Lackfenster vorhandene Verjüngung auf das Fenster im Siliciumdioxid übertragen. In der Folge wird dann diese Verjüngung auf das Silicium übertragen, sofern nicht ein hohes Verhältnis der Geschwindigkeit des Siliciumätzens zu der des Siliciumdioxidätzens eingestellt wird. Die Verjüngung in der Siliciumdioxidmaske liegt bevorzugt in dem Verjüngungswinkelbereich zwischen 5 und 20°. Wenn bei dem Lithographieverfahren Fenster im Lack mit vertikalen Lochwänden entstehen, dann werden auch die Fenster im Siliciumdioxid vertikale Lochwände aufweisen und es ist unter diesen Bedingungen so, daß die Öffnungen im Silicium praktisch auch vertikale Lochwände haben werden, und zwar unabhängig von dem Verhältnis der Geschwindigkeit des Siliciumätzens zu der Geschwindigkeit des Siliciumdioxidätzens.

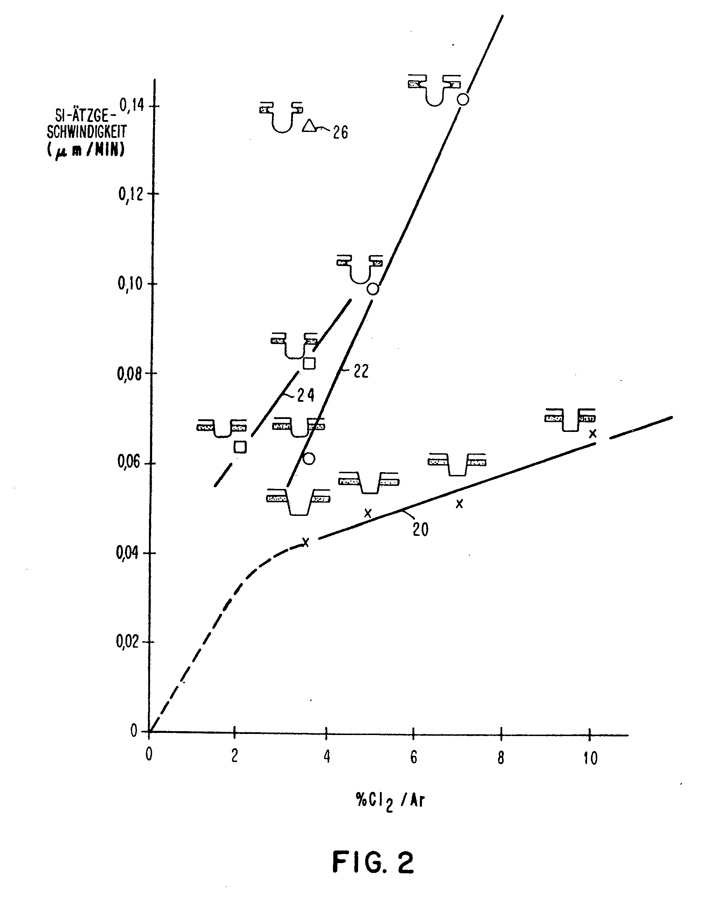

Die Änderung der Ätzgeschwindigkeiten beeinflußt auch das Unterätzen von hoch dotierten Bereichen vom $N^+$- oder $P^-$-Typs, wie z.B. des Bereichs 12. Bei Ätzgeschwindigkeiten von ungefähr 0,07 $\mu$m pro Minute, werden in Bereichen vom $N^+$-Typ Löcher mit vertikalen Wänden ohne laterale Unterätzung erzeugt. Wie die Fig. 2 zeigt, wird ein Erniedrigen der Ätzgeschwindigkeiten eine zunehmend stärkere Verjüngung verursachen. Die Fig. 2 ist ein Diagramm, welches den Einfluß der Siliciumätzgeschwindigkeit in $\mu$m pro Minute in Abhängigkeit von dem Prozentgehalt des chlorhaltigen Materials im Argon für verschiedene Drucke in der Reaktionskammer zeigt. Die Kurve 20 zeigt die Verhältnisse bei einem Druck von 13, 33 $\mu$bar. Bei diesem Druck und bei den angegebenen Ätzgeschwindigkeiten findet praktisch keine Unterätzung in den Bereichen vom $N^+$-Typ statt, wobei es gleichgültig ist, wie hoch der Prozentgehalt des chlorhaltigen Materials ist.

Man ersieht aus der Kurve 20, daß bei einer Änderung des Gehalts des chlorhaltigen Materials im Argon von 10% bis etwa 3% sich der Verjüngungswinkel in den Löchern von etwa 0 bis etwa 20° ändert. Bei allen in der Fig. 2 wiedergegebenen Experimenten ist die Leistung 0,16 W/cm² und die Kathode besteht aus Siliciumdioxid. Die Kurve 22 zeigt, daß bei einer Ätzgeschwindigkeit von 0,06 $\mu$m pro Minute und einem Chlorgehalt in Argon von etwa 3% eine Nut mit vertikalen Wänden erhalten wird. Wenn man sich auf der Kurve nach oben bis zu einer Ätzgeschwindigkeit von 0,10 $\mu$m pro Minute und einem Gehalt des chlorhaltigen Materials im Argon von 5% bewegt, dann erkennt man die Unterätzung in dem Bereich vom $N^+$-Typ. Bewegt man sich auf der Kurve noch weiter nach oben bis zu einer Ätzgeschwindigkeit von 0,14 $\mu$m pro Minute und etwa einem Gehalt des chlorhaltigen Materials im Argon von 7%, ist ein übermäßiges Unterätzen zu sehen, welches sehr ernst ist. Die Kurve 24 zeigt die Situation bei einem Druck von 53,33 $\mu$bar. Bei einem Gehalt des chlorhaltigen Materials im Argon von 2% und etwa einer Ätzgeschwindigkeit von 0,06 $\mu$m pro Minute, ist die Unterätzung im $N^+$-Bereich kein Problem. Bewegt man sich jedoch auf der Kurve aufwärts bis zu einer Ätzgeschwindigkeit von 0,08 $\mu$m, beginnt die Unterätzung deutlich zu werden. Es ist anzunehmen, daß wenn man sich auf der Kurve noch weiter nach oben bewegt, das Unterätzen noch stärker wird. Bei dem Punkt 26 ist das Verhältnis bei einem Gesamtdruck von 119,99 $\mu$bar wiedergegeben. Man erkennt ein extensives Unterätzen, welches zu einem nicht befriedigenden Produkt führt. Man ersieht aus dem Diagramm in der Fig. 2, daß brauchbare Betriebsbedingungen vorliegen, wenn der Druck im Bereich zwischen etwa 2,66 und etwa 66,6 $\mu$bar, die Konzentration des chlorhaltigen materials in der Gasatmosphäre zwischen etwa 2 und etwa 10% und die Ätzgeschwindigkeit zwischen etwa 0,04 und 0,08 $\mu$m pro Minute liegen. Die chlorhaltigen Materialien, mit welchen die genannten Ergebnisse erzielt werden, sind $Cl_2$, $CCl_4$, $CHCl_3$ und andere Chlor enthaltende Materialien.

Das Hauptproblem, welches aus dem Unterätzen des $N^+$-Bereichs folgt, ist, daß es den minimalen Abstand, welchen zwei Isolationsbereiche voneinander haben können, nach unten begrenzt. Wenn ein sehr starkes Unterätzen auftritt, und zwei Isolationsbereiche sehr nahe beieinanderliegen, wird eine vollständige Unterätzung des Bereichs 14 eintreten. Darüber hinaus wird der $N^+$-Kollektorbereich vollständig entfernt werden, so daß kein Transistor gebildet werden kann. Noch ein weiteres Problem wird in jedem unterätzten Bereich dadurch auftreten, daß die sich nicht linear verjüngenden Löcher nicht sauber mit dielektrischem, mittels chemischen Niederschlagens aus der Dampfphase abgeschiedenem Material, wie z.B. Siliciumdioxid, gefüllt werden. Die Folge ist eine gefüllte Nut, welche ein vergrabenes Loch oder einen vergrabenen Kanal enthält.

Bezugnehmend auf die Fig. 1C wird nun der nächste Schritt in dem erfindungsgemäßen Verfahren besprochen. Bei diesem Schritt werden die Öffnungen oder Kanäle thermisch oxidiert, indem der Halbleiterkörper einer oxidierenden Atmosphäre, beispielsweise einer feuchten Sauerstoffatmosphäre bei 970°C, ausgesetzt wird. Der Halbleiterkörper wird der Atmosphäre zwischen etwa 10 und etwa 30 Minuten ausgesetzt, um die bevorzugte Siliciumdioxiddicke innerhalb der Öffnung oder des Kanals zu erzeugen. Die bevorzugte Dicke liegt zwischen etwa 0,05 und etwa 0,2 $\mu$m. Der Zweck des thermischen Oxids 30 ist es, gute Eigenschaften der Grenzfläche zwischen dem Silicium und dem Siliciumdioxid sicherzustellen. Dielektrisches Material, welches mittels chemischen Niederschlagens aus der Dampfphase aufgebracht worden ist, hat im allgemeinen nicht so gute Eigenschaften wie thermisch gewachsenes Oxid. Dielektrisches Material mit guten Eigenschaften ist aber notwendig, um anschließend das Anstoßen von diffundierten P/N-Übergängen an die dielektrische Isolation zu erlauben.

Die minimale Dicke muß nominell 0,05 $\mu$m sein, damit eine gute thermische Siliciumdioxidschicht vorliegt. Eine dünnere Schicht könnte dadurch Schwierigkeiten verursachen, daß durchgehende Poren im Oxid vorhanden sind, und könnte dadurch Probleme mit der elektrischen Integrität verursachen.

Die maximale Dicke wird hauptsächlich bestimmt durch die Zeit, welche bei erhöhten Temperaturen zum Aufwachsen erforderlich ist. Lange Aufwachszeiten bei hohen Temperaturen führen dazu, daß sich jeder diffundierte P/N-Übergang in den Siliciumbereichen bewegt. Sehr dicke Oxidfilme, welche bei solchen Temperaturen erzeugt worden sind, verursachen auch Spannungsprobleme im Siliciummaterial.

Das thermisch gewachsene Oxid 30 folgt fast exakt der Verjüngung der Seitenwände der Öffnung, welche mittels reaktiven Ionenätzens erzeugt worden ist. Das Ergebnis des nächsten Verfahrensschritts, bei welchem die Öffnungen mit einem geeigneten dielektrischen Material gefüllt werden, ist in der Fig. 1 D gezeigt aus der man ersieht, daß die Öffnung bzw. der Kanal mit einer aus mittels Niederschlagens aus der Dampfphase erzeugtem Siliciumdioxid bestehenden Schicht 32 gefüllt ist. Um die Öffnung bzw. den Kanal vollständig zu füllen ist es notwendig, die Oberfläche der Schicht 30 nicht nur im Kanal bzw. in der Öffnung, sondern vollständig über die gesamte Oberfläche des Siliciumkörpers zu bedecken. Bei dem bevorzugten Füllprozeß handelt es sich um ein chemisches Niederschlagen von Siliciumdioxid aus der Dampfphase bei 800 bis 1000°C unter Verwendung von Gasmischungen, welche $CO_2$, $SiH_4$ und $N_2$ oder $N_2O$, $SiH_4$ und $N_2$ enthalten.

Typische Abscheidungsgeschwindigkeiten liegen größenordnungsmäßig zwischen 5 und 10 nm/Min. und die Gesamtdicke der abgeschiedenen Schichten liegt für 2 $\mu$m breite Nuten bei nominell 3 $\mu$m, wenn eine angenähert planare Oberfläche gewünscht wird. Die spezielle Beziehung zwischen der Ebenheit und der Dicke des mittels chemischen Niederschlagens aus der Dampfphase aufgebrachten Siliciumdioxids, ist in der Fig. 8 aufgezeigt.

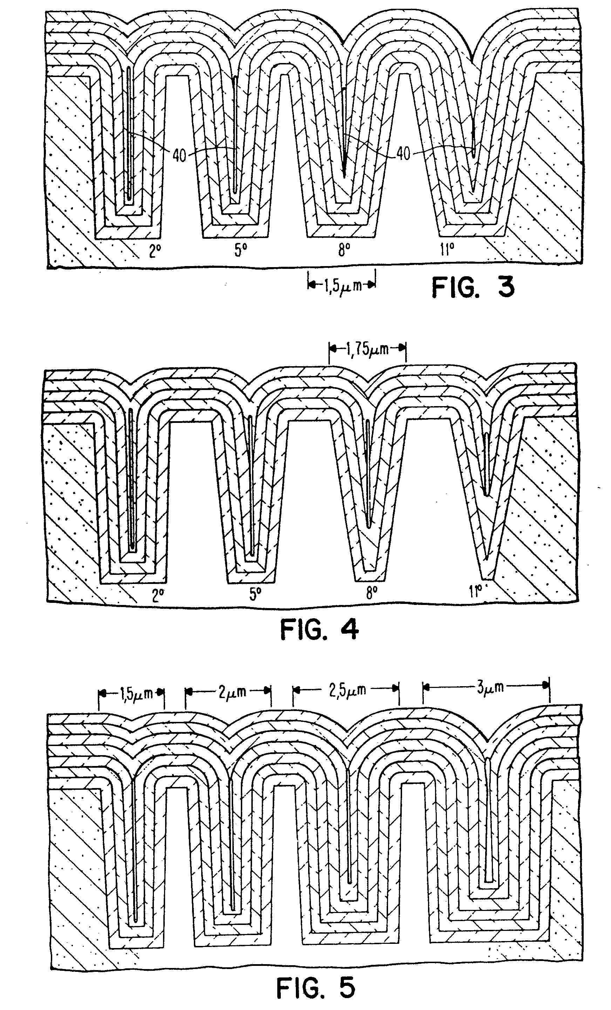

Die Probleme, welche beim Füllen von Öffnungen oder Kanälen auftreten, lassen sich einleuchtender anhand der Fign. 3, 4 und 5 erläutern. Diese Fign. zeigen die ausschlaggebende Bedeutung des Verjüngungswinkels der Lochseitenwände und der Lochabmessungen an der Siliciumoberfläche. In der Fig. 3 sieht man im mittleren Teil der mit mittels chemischen Niederschlagens aus der Dampfphase aufgebrachtem Siliciumdioxid gefüllten Öffnungen einen schmalen Füllungsspalt 40. Diesen Füllungsspalt sieht man erst, nach dem man einen Querschnitt durch den mit $SiO_2$ gefüllten Kanal geätzt hat. Die Bildung des Füllungsspaltes verursacht ein Oxid mit schlechten Eigenschaften in diesem Bereich und Experimente zeigen, daß der Spalt sich dadurch bildet, daß das Siliciumdioxid über Öffnungen, welche schmäler sind als 0,2 $\mu$m und deren Verjüngswinkel kleiner als 20° ist, unter Bedeckung des Lochs hinüberwächst. Es ist festgestellt worden, daß der Verjüngungswinkel der Öffungswände mit dem fortschreitenden Füllen der Öffnung abnimmt (s. Fig. 6). Dies kann das Überbrücken mit dem Oxid auf verschiedene Art und Weise beeinflussen, wobei der spezielle Effekt mit der Lochbreite und dem Verjüngswinkel zusammenhängt. Diese Effekte sind in den Fign. 3, 4 und 5 gezeigt. Sie illustrieren durch eine Serie von Linien, welche gleiche Schichtdickenbereiche aus mittels chemischen Niederschlagens aus der Dampfphase aufgebrachtem Siliciumdioxid repräsentieren, das fortschreitende Auffüllen der Nuten. Wie in der Fig. 3 gezeigt ist, tendiert der Füllungsspalt 40 dazu, weiter unten in der aufgefüllten Nut begraben zu werden, wenn die Nutbreite sich verbreitert und der Verjüngungswinkel zunimmt. Fig. 4 zeigt anhand von Nuten mit gleicher Breite den Einfluß des Verjüngungswinkels. Man sieht noch einmal, daß in den sich stärker verjüngenden Nuten der Füllungsspalt bzw. der Bereich aus schlechtem Siliciumdioxid tiefer vergraben wird. Fig. 5 zeigt anhand von vier Nuten mit demselben Verjüngungswinkel den Einfluß der Nutbreite. Mit zunehmender Breite der Nut verschiebt sich der obere Rand des Bereichs aus schlechtem Oxid nach oben.

Diese Ergebnisse sind in der Fig. 7 aufsummiert, in welcher die Erstreckung $\Delta l$ des Füllungsspaltes bis über oder unter die Oberfläche des Siliciumplättchens für verschiedene Verjüngungswinkel über der Nutbreite aufgetragen ist. Es geht aus der Fig. klar hervor, daß man erfolgreich vergrabene Bereiche aus schlechtem Siliciumdioxid dann erhält, wenn die Nutbreiten schmal und die Verjüngungswinkel klein sind. Wird die Nutbreite verbreitert, muß der Verjüngungswinkel entsprechend vergrößert werden, damit das schlechte Oxid vergraben bleibt.

Die Fig. 6 enthält experimentelle Daten, welche die Änderung des Verjüngungswinkels (in der Fig. 6 mit $\measuredangle \alpha$ bezeichnet) der Lochwandung mit der fortschreitenden Auffüllung der Nut aufzeigen. Es ist offensichtlich, daß wenn man von Nuten mit vertikalen Wänden ausgeht, man beim Abscheiden Nuten mit negativem Verjüngungswinkeln erhält, aus denen in der Folge Lunker im Siliciumdioxid resultieren.

Fig. 8 enthält experimentelle Werte betreffend die notwendige Dicke des mittels chemischen Niederschlagens aus der Dampfphase aufgebrachten Siliciumdioxids ($CVD_{SiO_2}$), um die Oberfläche über einer Nut vollständig zu planarisieren. Die notwendige Schichtdicke um dies zu erreichen, hängt zusammen mit der Nutbreite am oberen Rand der Nut.

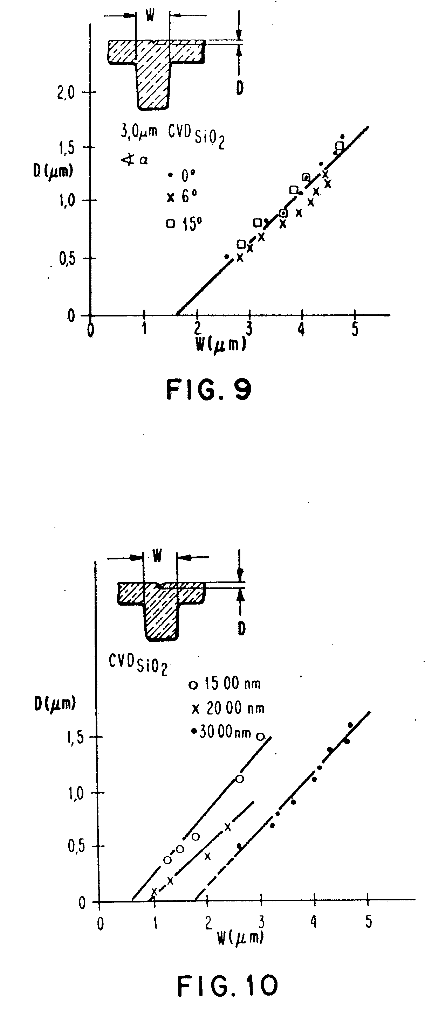

Die Fig. 9 zeigt ähnliche experimentelle Daten, d.h. solche, welche das Füllen von Nuten und die Planarität betreffen, wie die Fig. 8, und unterstreicht noch, daß die Planarisierung streng von der Nutbreite und nicht von dem Verjüngungswinkel $\alpha$ abhängt.

Die Fig. 10 zeigt in einem weiteren Diagramm den Einfluß der Nutbreite für verschiedene Überdeckungsdicken auf die Oberflächenplanarität.

Der letzte Schritt des Verfahrens ist das reaktive Ionenätzen der in Fig. 1D gezeigten Siliciumdioxidschicht 32, wobei die in der Fig. 1E gezeigte Struktur erzeugt wird.

Der Überschuß des Siliciumdioxids wird bequem mittels reaktiven Ionenätzens und mit der Hilfe eines optischen Filmdickenmeßsystems oder wenn die Geschwindigkeit, mit der das Siliciumdioxid geätzt wird, bekannt ist, auch ohne ein solches System, entfernt. Die Vorrichtung, welche für diesen Verfahrensschritt benutzt wird, besteht bevorzugt aus einer Vorrichtung zum Kathodenzerstäubungsätzen bei niedrigem Druck, in der das Plättchen auf einer Kathodendeckplatte aus Silicium positioniert ist. Ein fluorierter Kohlenwasserstoff, wie z.B. $CF_4$ kann als Ätzmittel verwendet werden, weil dann das Verhältnis der Geschwindigkeit des $SiO_2$-Ätzens zu der des Si-Ätzens ungefähr 1:1 ist. Der Gasdruck kann im Bereich zwischen 13,33 und 93,3 $\mu$bar und der Gasfluß im Bereich zwischen 2 und 50 ccm/min liegen. Der Hochfrequenzleistungspegel liegt bevorzugt im Bereich zwischen etwa 0,1 und 0,5 W/cm². Das Ergebnis des Dünnens der Siliciumdioxidschicht mittels reaktiven Ionenätzens kann sein, daß der nicht genügend vergrabene Bereich aus schlechtem Oxid in der Mitte der Nut sichtbar wird. Das ist ein potentielles Problem, weil bei jedem Naßätzen der Plättchenoberfläche, wenn solche Bereiche aus schlechtem Siliciumdioxid freiliegen, eine Spaltbildung in diesem Bereich verursacht würde. Solche Spalte könnten potentielle Fallen für Schmutz oder Prozeßrückstände werden, und könnten die Eigenschaften des Bauteils negativ beeinflussen. Ein alternatives Verfahren, um einige der Unterätzprobleme zu umgehen, würde so aussehen, daß ein hochdotierter Bereich 12 in einer solchen Art und Weise hergestellt wird, daß dieser Bereich Dort unterbrochen ist, bzw. Aussparungen aufweist, wo die Öffnungen oder Kanäle gebildet werden sollen. In diesem Fall würde ein schwach dotierten Bereich vom P⁻-Typ den Bereich umgeben, welcher mittels reaktiver Ionen geätzt werden soll. Auf diese Weise würde ein Unterätzproblem vermieden. Diese Alternative erfordert spezielle Oxidations-, Photolithographie- und Ätzschritte, damit dieser Bereich vom N⁺-Typ mit Aussparungen entsteht. Die Bildung eines Bereichs vom P⁺-Typ unterhalb des Isolationsbereichs kann nützlich sein, wenn das Substrat vom P⁻-Typ ist. In solchen Fällen hat der P⁻-Bereich die Tendenz, seinen Widerstand zu ändern, was soweit gehen kann, daß das Material aus dem er besteht, wenn er thermisch oxidiert wird, in ein solches vom N-Typ invertiert wird. Ein P⁺-Bereich verhindert eine solche Inversionsmöglichkeit. Ein solcher Bereich kann durch das Einbringen eines Dotierungsstoffs, wie z.B. Bor, mittels Ionenimplantation vor der thermischen Oxidation der Nut erzeugt werden. Bei der Ionenimplantation geht man am besten so vor, daß die Nut mit einer dünnen, mittels chemischen Niederschlagens aus der Dampfphase erzeugten Siliciumdioxidschicht bedeckt wird. Eine solche zwischen etwa 50 und 80 nm dicke Bedeckung erlaubt die Implantation beispielsweise von Bor durch den Boden der Nut hindurch in das Silicium aber nicht durch das Siliciumdioxid auf den Seitenwänden der Nut hindurch. Dies ist so, weil der Ionenstrahl mit den Seitenwänden der Nut einen spitzen Winkel bildet und deshalb die Wegstrecke durch das Siliciumdioxid bis zum Silicium größer ist, als die echte Dicke des Siliciumdioxids beträgt. Nach der Implantation und einem geeigneten Temperschritt, wird das mittels chemischen Niederschlagens aus der Dampfphase erzeugte Siliciumdioxid entfernt und dann wird die normale Prozeßschrittfolge, welche oben anhand der Fign. 1C bis 1E besprochen worden ist fortgesetzt.

Eine andere Möglichkeit, den Fabrikationsprozeß zu modifizieren, besteht darin, die halbleitersubstrate nach dem Prozeßschritt, bei welchem die in der Fig. 1E gezeigte Struktur entsteht, einem Temperschritt in einer Wasserdampfatmosphäre zu unterwerfen. Diese Temperung, welche bei einer Temperatur im Bereich zwischen 900 und 950°C durchgeführt wird, wird irgendwelches im Mittelbereich der Nut freiliegendes Siliciumdioxid schlechter Qualität in ein solches von guter Qualität umgewandelt. Der Vorteil dieser Prozeßmodifikation besteht darin, daß es bei ihrer Anwendung nicht mehr so wichtig ist, daß die Bereiche aus Siliciumdioxid schlechter Qualität mit Sicherheit vergraben sind und daß es deshalb nicht mehr so wichtig ist, daß die Verjüngungswinkel möglichst groß sind, weshalb es möglich ist, eine höhere Bauteildichte bei der Herstellung von integrierten Schaltkreisen vorzusehen. Mit der Prozeßmodifikation ist es beispielsweise möglich, Siliciumdioxid schlechter Qualität, welches beim Vorliegen kleiner Verjüngungswinkel, wie z.B. solchen im Bereich zwischen 2 und 4° entstanden ist, in solches von guter Qualität umzuwandeln.

Das erfindungsgemäße Verfahren ist nicht auf die in den Ausführungsbeispielen beschriebenen Anwendungen beschränkt. Beispielsweise können die mittels des beschriebenen Verfahrens erzeugten einkristallinen Siliciumbereiche auch zur Ausbildung anderer Bauteile als von Bipolartransistoren benutzt werden. Solche Bauteile würden passive Bauteile wie z.B. Widerstände und aktive Bauteile wie z.B. Metall-Oxid-Silicium-Feldeffektransistoren (MOSFET)-Bauteile einschließen.

**Patentansprüche**

1. Verfahren zum Herstellen von lateral isolierten Bereichen in einem Siliciumkörper, bei dem Nuten an den Stellen, an welchen der Isolationsrahmen entstehen soll, mittels reaktiven Ionenätzens in das Silicium geätzt, anschließend oberflächlich thermisch oxidiert und dann mit dielektrischem Material gefüllt werden, wobei das dielektrische Material mit der notwendigen Dicke ganzflächig auf den Siliciumkörper aufgebracht wird, um die Oberfläche der Nute zu planarisieren, und schließlich das dielektrische Material außerhalb der Nute weggeätzt wird, dadurch gekennzeichnet, daß unter Anwendung einer Maske aus einem Material aus der Gruppe Siliciumdioxid, Siliciumnitrid, Aluminiumoxid oder Kombinationen dieser Materialien mit in Richtung der Siliciumoberfläche sich verjüngenden Maskenfenstern die Nuten in den Siliciumkörper mit einer über den Gasdruck in der Reaktionskammer, die Konzentration des reaktiven Gases in der Reaktionsatmosphäre und die Hochfrequenz-Leistungsdichte derart auf diejenige des Maskenmaterials abgestimmten Ätzgeschwindigkeit erzeugt werden, daß sie sich in der Tiefe verjüngen und einen flachen Boden aufweisen.

2. Verfahren nach Anspruch 1, dadurch gekennzeichnet, daß Nuten erzeugt werden, deren Breite am oberen Rand maximal 4 $\mu$m ist, und deren Seitenwände einen Verjüngungswinkel im Bereich zwischen etwa 2 und etwa 20° aufweisen.

3. Verfahren nach Anspruch 1 oder 2, dadurch gekennzeichnet, daß beim reaktiven Ionenätzen ein reaktives Gas verwendet wird, welches aus einem Halogen aus der Gruppe Chlor, Brom, Jod bzw. einem eines dieser Elemente enthaltenden Material besteht und der Reaktionsatmosphäre in Mengen im Bereich zwischen 2 und etwa 10% zugesetzt wird, daß bei einem Druck in der Reaktionskammer im Bereich zwischen etwa 2,66 und etwa 66 $\mu$bar gearbeitet und die Ätzgeschwindigkeit auf einen Wert im Bereich zwischen etwa 0,03 und etwa 0,08 $\mu$m/Min. eingestellt wird.

4. Verfahren nach einem oder mehreren der Ansprüche 1 bis 3, dadurch gekennzeichnet, daß ein Siliciumkörper (10) verwendet wird, welcher mindestens eine hochdotierte Schicht (12) enthält und daß die Nuten so tief geätzt werden, daß sie im wesentlichen die hochdotierte Schicht (12) durchdringen.

5. Verfahren nach Anspruch 3 oder 4, dadurch gekennzeichnet, daß in einer Argonatmosphäre, welcher als reaktives Gas Chlor in Mengen von ≤8% zugesetzt ist, gearbeitet wird.

6. Verfahren nach einem oder mehreren der Ansprüche 1 bis 5, dadurch gekennzeichnet, daß in bekannter Weise auf einer auf dem Siliciumkörper aufgebrachten SiO$_2$-Schicht (16) eine entsprechend dem gewünschten Muster der Nuten ausgebildete-Photolackmaske erzeugt wird und daß dann die SiO$_2$-Schicht (16) so reaktiv geätzt wird, daß das Ätzgeschwindigkeitsverhältnis von SiO$_2$: Photolack ungefähr eins ist.

7. Verfahren nach Anspruch 6, dadurch gekennzeichnet, daß in der SiO$_2$-Schicht (16) Öffnungen (18), deren Seitenwande einen Verjüngungswinkel im Bereich zwischen etwa 5 und etwa 20° aufweisen, erzeugt werden.

8. Verfahren nach einem oder mehreren der Ansprüche 1 bis 7, dadurch gekennzeichnet, daß beim thermischen Oxidieren eine ungefähr 0,2 $\mu$m dicke Siliciumdioxidschicht (30) erzeugt wird.

9. Verfahren nach einem oder mehreren der Ansprüche 1 bis 8, dadurch gekennzeichnet, daß das zum Füllen der Nuten verwendete dielektrische Material (32) mittels chemischen Niederschlagens aus der Dampfphase erzeugt und in einer Dicke im Bereich zwischen etwa 1 und etwa 5 $\mu$m abgeschieden wird, wobei die für die Planarisierung notwendige Mindestdicke in Abhängigkeit von der Breite der Nut am oberen Rand festgelegt wird, und daß das dielektrische Material (32) mittels reaktiven Ionenätzens entfernt wird.

10. Verfahren nach einem oder mehreren der Ansprüche 1 bis 9, dadurch gekennzeichnet, daß nach dem Wegätzen des mittels chemischen Niederschlagens aus der Dampfphase erzeugten dielektrischen Materials (32) der Siliciumkörper bei einer Temperatur im Bereich zwischen etwa 900 und etwa 950°C einer Behandlung mit Wasserdampf unterworfen wird.

11. Verfahren nach einem oder mehreren der Ansprüche 1 bis 10, dadurch gekennzeichnet, daß, wenn die Nuten bis in einen Bereich vom P-Typ reichen, in den Bodenbereich der Nuten vor dem thermischen Oxidieren Verunreinigungen, welche eine P-Leitfähigkeit vermitteln, in einer solchen Menge implantiert werden, daß lokal ein Bereich vom P$^+$-Typ entsteht.

## Revendications

1. Procédé pour fabriquer des régions de silicium isolées latéralement, dans lequel l'on forme des rainures dans un corps en silicium par un décapage par ions réactifs et ceci aux emplacements prévus pour le cadre d'isolement; dans lequel l'on oxyde ensuite thermiquement la surface des rainures que l'on remplit d'un matériau diélectrique, ce matériau diélectrique étant déposé, avec l'épaisseur désirée, sur toute la surface du corps de silicium afin d'aplanir la surface des rainures; et dans lequel on décape enfin le matériau diélectrique à l'extérieur de la rainure; caractérisé en ce que l'utilisation d'un masque composé d'un matériau choisi dans le groupe comprenant le dioxyde de silicium, le nitrure de silicium, l'oxyde d'aluminium ou des combinaisons de ces matériaux dont les ouvertures se rétrécissent vers la surface de silicium permet de produire ces rainures dans le corps de silicium avec une vitesse de décapage qui est adaptée à celle du matériau constituant le masque par la pression de gaz dans la chambre de réaction, la concentration du gaz réactif dans l'atmosphère de réaction et la densité du courant hautes fréquences de telle sorte que les rainures se rétrécissent en profondeur et présentent un fond plat.

2. Procédé selon la revendication 1, caractérisé en ce que l'on produit des rainures dont la largeur maximum au bord supérieur est de 4 $\mu$m, et dont les parois latérales présentent un angle de rétrécissement compris entre environ 2 et environ 20°.

3. Procédé selon la revendication 1 ou 2, caractérisé en ce que l'on utilise pour le décapage par ions réactifs un gaz réactif qui est composé d'un halogène du groupe comprenant le chlore, le brome, l'iode ou un matériau comprenant un de ces éléments et qui est ajouté à l'atmosphère de réaction dans des quantités comprises entre environ 2 et environ 10%, en ce que l'on utilise une pression dans la chambre de réaction comprise entre environ 2,66 et environ 66 $\mu$bar et en ce que l'on ajuste la vitesse de décapage à une valeur comprise entre environ 0,03 et environ 0,08 $\mu$m/minute.

4. Procédé selon l'une ou plusieurs des revendications 1 à 3, caractérisé en ce que l'on utilise un corps de silicium (10) comportant au moins une couche fortement dopée (12), et en ce que l'on décape les rainures à une profondeur telle qu'elles pénètrent essentiellement dans la couche fortement dopée (12).

5. Procédé selon la revendication 3 ou 4, caractérisé en ce que l'on utilise une atmosphère d'argon à qui l'on ajoute comme gaz réactif du chlore dans des quantités de $\leq 8\%$.

6. Procédé selon l'une quelconque ou plusieurs des revendications 1 à 5, caractérisé en ce que l'on produit, de la façon connue, sur une couche de SiO$_2$ (16) déposée sur le corps de silicium un masque de résine photosensible réalisé selon la configuration désirée des rainures et en ce que l'on décape réactivement la couche de SiO$_2$ (16) de telle sorte que le rapport de vitesse de décapage entre le SiO$_2$ et la résine photosensible est à peu près égal à 1.

7. Procédé selon la revendication 6, caractérisé en ce que dans la couche de SiO$_2$ (16) des ouvertures (18) sont prévues dont les parois latérales ont un angle de rétrécissement compris entre approximativement 4 et approximativement 20°.

8. Procédé selon l'une ou plusieurs des revendications 1 à 7, caractérisé en ce que dans l'oxydation thermique une couche d'oxyde de silicium (30), d'approximativement 0,2 $\mu$m d'épaisseur, est générée.

9. Procédé selon l'une ou plusieurs des revendications 1 à 8, caractérisé en ce que l'on produit le matériau diélectrique (32) utilisé pour remplir les rainures à l'aide d'un dépôt chimique en phase vapeur et qu'il est déposé avec une épaisseur comprise entre environ 1 et environ 5 $\mu$m, l'épaisseur minimum nécessaire pour obtenir la planéarité étant déterminée en fonction de la largeur de la rainure au bord supérieur, et en ce que l'on enlève le matériau diélectrique (32) à l'aide du décapage par ions réactifs.

10. Procédé selon l'une quelconque ou plusieurs des revendications 1 à 9, caractérisé en ce que l'on soumet le corps de silicium à un traitement par vapeur d'eau à une température comprise entre environ 900 et environ 950°C après avoir décapé le matériau diélectrique (32) produit à l'aide du dépôt chimique en phase vapeur.

11. Procédé selon l'une quelconque ou plusieurs des revendications 1 à 10, caractérisé en ce que, lorsque les rainures pénètrent jusqu'à une région du type P, l'on implante dans la région constituant le fond des rainures, et préalablement à l'oxydation thermique, des impuretés du type P, avec une concentration telle que l'on forme localement une région du type P$^+$.

## Claims

1. Method of making laterally isolated regions in a silicon body, where in those places where the isolation frame is to be made grooves are etched into the silicon by means of reactive ion etching, subsequently thermally oxidized on the surface, and then filled with dielectric material, the dielectric material being applied in a blanket deposition on the silicon body with the necessary thickness to ensure a planar surface of the grooves, and wherein finally the dielectric material outside the opening is etched off, characterized in that by using a mask of a material selected from the group containing silicon dioxide, silicon nitride, aluminium oxide, or combinations of these materials, with windows tapering in the direction of the silicon surface, the grooves are made in the silicon body with an etching speed adapted, by means of the gas pressure in the reaction chamber, the concentration of the reactive gas in the reaction atmosphere, and the high frequency power density, to that of the mask material in such a manner that they taper with their depth and have a flat bottom.

2. Method as claimed in claim 1, characterized in that grooves are made which at their upper edge are at most 4 $\mu$m wide, and the taper of whose walls is between approximately 2 and approximately 20°.

3. Method as claimed in claim 1 or 2, characterized in that in reactive ion etching a reactive gas is used which consists of a halogen selected from the group containing chlorine, bromine, iodine, or of a material containing one of these elements, and which is admixed to the reaction atmosphere in quantities between 2 and approximately 10%, that the process takes place at a pressure in the reaction chamber between approximately 2.66 and approximately 66 $\mu$bar, and that the etching speed is set at a value between approximately 0.03 and approximately 0.08 $\mu$m/min.

4. Method as claimed in one or several of claims 1 to 3, characterized in that a silicon body (10) is used which contains at least one highly doped layer (12), and that the grooves are etched to such a depth that they substantially penetrate the highly doped layer (12).

5. Method as claimed in claim 3 or 4, characterized in that the process takes place in an argon atmosphere to which chlorine in quantities of $\leq 8\%$ is admixed as a reactive gas.

6. Method as claimed in one or several of claims 1 to 5, characterized in that in a known manner on an SiO$_2$ layer (16) applied on the silicon body, a photoresist mask is generated which is formed in accordance with the desired pattern of the grooves, and that subsequently the SiO$_2$ layer (16) is reactively etched in such a manner that the etching speed ratio of SiO$_2$: photoresist is approximately one.

7. Method as claimed in claim 6, characterized in that in the SiO$_2$ layer (16) openings (18) are made whose walls taper between approximately 5 and approximately 20°.

8. Method as claimed in one or several of claims 1 to 7, characterized in that in thermal oxidation an approximately 0.2 $\mu$m thick silicon dioxide layer (30) is generated.

9. Method as claimed in one or several of claims 1 to 8, characterized in that the dielectric material (32) used for filling the grooves is generated by means of chemical vapour deposition and deposited in a thickness between approximately 1 and approximately 5 $\mu$m, the minimum thickness required for obtaining a planar surface being determined as a function of the width of the grooves its upper edge, and in that the dielectric material (32) is removed by means of reactive ion etching.

10. Method as claimed in one or several of claims 1 to 9, characterized in that after the etching off of the dielectric material (32) generated by means of chemical vapour deposition, the silicon body is exposed to a steam treatment at a temperature between approximately 900 and approximately 950°C.

11. Method as claimed in one or several of claims 1 to 10, characterized in that if the grooves reach down to a P-type region impurities imparting a P-conductivity are implanted in the bottom region of the openings prior to the thermal oxidation, in such a quantity that a region of the P$^+$-type is generated locally.

FIG. 1A

FIG. 1B

FIG. 1C

FIG. 1D

FIG. 1E

FIG. 2

0 000 897

FIG. 3

FIG. 4

FIG. 5

OXID-INNEN- ∢
(°)

OXID-INNEN ∢

∢ a

**FIG. 6**

CVD SiO₂ (µm)

Δℓ
(µm)

2°

5°

7°

9°-10°

10°-14°

**FIG. 7**

OBERE NUT-BREITE (µm) ⟶

W

D

NUT-BREITEN:
• 3,0 µm
× 2,0 µm
□ 1,0 µm

**FIG. 8**

D (µm)

CVD SiO₂ (µm)

4

FIG. 9

FIG. 10